# EUROPÄISCHE PATENTSCHRIFT

(11) **EP 4 252 497 B1**
(45) Veröffentlichungstag und Bekanntmachung des Hinweises auf die Patenterteilung: **24.07.2024**
(21) Anmeldenummer: 21819802.6
(22) Anmeldetag: 24.11.2021
(51) Int. Cl.: H05K 7/20

(54) **LEISTUNGSMODUL MIT EINER ISOLIERT GETEILTEN WÄRMESENKE UND FAHRZEUG MIT DEM LEISTUNGSMODUL**
POWER MODULE WITH AN INSULATED, DIVIDED HEATSINK, AND VEHICLE WITH A POWER MODULE
MODULE DE PUISSANCE COMPRENANT UN DISSIPATEUR THERMIQUE À PLUSIEURS PARTIES ISOLÉES ET VÉHICULE COMPRENANT CE MODULE DE PUISSANCE

(30) Priorität: 25.11.2020 DE 102020214795
(43) Veröffentlichungstag der Anmeldung: 04.10.2023
(73) Patentinhaber: Robert Bosch GmbH, 70442 Stuttgart (DE)
(72) Erfinder: MEHRINGER, Paul, 70569 Stuttgart (DE); SCHOLZ, Benedikt, 70825 Korntal (DE); FOTSO SIMO, Narcisse, 72762 Reutlingen (DE); MUTSCHLER, Marcus, 74385 Pleidelsheim (DE)
(86) Internationale Anmeldenummer: PCT/EP2021/082778
(87) Internationale Veröffentlichungsnummer: WO 2022/112302

(56) Entgegenhaltungen:
- DE-A1- 102010 041 589
- DE-A1- 19 756 250

## Beschreibung

### Stand der Technik

Die Erfindung betrifft ein Leistungsmodul, insbesondere Antriebsmodul. Das Leistungsmodul weist eine zum ein Fluidführen ausgebildete Wärmesenke, insbesondere Kühlkörper, und wenigstens zwei zueinander verschiedene Leistungsbauteile auf. Die Leistungsbauteile sind jeweils mit der Wärmesenke, insbesondere einem Teil der Wärmesenke, wärmeleitfähig oder zusätzlich elektrisch leitfähig verbunden.

Aus der DE 197 56 250 C2 ist ein selbstgeführter Stromrichter eines spannungseinprägenden Umrichters mit Hochleistungsmodulen bekannt, welche phasenweise jeweils mit einem Phasenkühlkörper lösbar verbunden sind, und derart übereinander mit einer Trennwand verbunden sind, dass deren Kühlrippen durch Aussparungen dieser Trennwand in einen Belüftungsraum ragen.

Aus der DE10 2010 041 589 A1 ist ein Gehäuse für eine Elektromaschine bekannt das an ein Gehäuseelement zur Aufnahme einer Leistungselektronik einer Elektromaschine abdichtend gekoppelt werden kann.

### Offenbarung der Erfindung

Erfindungsgemäß sind die Leistungsbauteile jeweils ausgebildet, zueinander verschiedene elektrische Potentiale, insbesondere Massepotentiale zu führen. Die Wärmesenke umfasst wenigstens oder nur zwei Teile, insbesondere ein Teil und ein weiteres Teil, welche jeweils einen Hohlraum zum Führen eines Fluidstromes aufweisen und welche mittels eines elektrischen Isolators derart miteinander verbunden sind, dass die Teile jeweils von einem beide Teile kühlenden Fluidstrom durchflossen werden können, wobei die Teile derart voneinander elektrisch isoliert sind, dass die elektrischen Potentiale der Leistungsbauteile innerhalb der Wärmesenke voneinander getrennt sind. Weiter vorteilhaft kann so über die Teile der Wärmesenke, welche beispielsweise aus Aluminium gebildet sind, kein Strom, insbesondere ein Massestrom, fließen. Weiter vorteilhaft kann durch einen solchen Massestrom an einem insbesondere wasserführenden Kühlkörper keine Korrosion, insbesondere Elektrokorrosion, beispielsweise durch Elektrolyse, eintreten.

Bevorzugt ist das Leistungsmodul ein Antriebsmodul für ein Kraftfahrzeug, insbesondere Elektrofahrzeug oder Hybridfahrzeug. Vorteilhaft kann eine Invertermasse von der Masse der elektrischen Maschine des Antriebs galvanisch getrennt oder hinreichend isoliert sein. Weiter vorteilhaft können so keine Elektrokorrosion verursachenden Masseschleifen gebildet sein, da durch die voneinander isolierten Teile der Wärmesenke die ein Massepfad an der Wärmesenke unterbrochen ist.

Bevorzugt sind die Teile der Wärmesenke jeweils durch ein Gehäuseteil, bevorzugt Aluminiumgehäuseteil gebildet, wobei die Gehäuseteile insbesondere trennbar miteinander verbunden sind und die Isolierschicht zwischeneinander einschließen. Vorteilhaft kann die Wärmesenke so ausgebildet sein, die Leistungsbauteile voneinander elektrisch zu isolieren.

Bevorzugt ist ein Teil der Wärmesenke mit einem Gehäuse eines Leistungsbauteils, insbesondere einer elektrischen Maschine, verbunden und der weitere Teil der Wärmesenke mit einem weiteren Leistungsbauteil, insbesondere einem Inverter, oder einem Gehäuse des weiteren Leistungsbauteils verbunden. Vorteilhaft können so Massepotentiale der Leistungsbauteile voneinander getrennt sein.

In einer vorteilhaften Ausführungsform ist der weitere Teil der Wärmesenke mittels des Isolierelements als Zwischenstück elektrisch getrennt - an einen Maschinengehäuse der Maschine angekoppelt. Eine Koppelfläche der Ankopplung an dem Maschinengehäuse kann dazu an einer Stirnseite, und somit quer zu einer Motorwelle verlaufen oder an einer Gehäuseseite angekoppelt sein und so parallel zur Motorwelle angeordnet sein. Vorteilhaft kann so ein Inverter nahe an eine elektrische Maschine von deren Gehäuse isoliert angekoppelt sein.

Die Wärmesenke ist bevorzugt aus Metall, insbesondere Aluminium oder Kupfer gebildet.

Vorteilhaft kann die Wärmesenke so eine gute Wärmeleitfähigkeit aufweisen.

In einer bevorzugten Ausführungsform des Leistungsmoduls ist der Isolator durch ein insbesondere flaches elektrisches Isolierelement oder eine elektrisch isolierende Schicht gebildet, welches durch die Teile kontaktiert ist, und zwischen den Teilen - insbesondere nach Art eines Sandwichs - eingeschlossen ist. Vorteilhaft kann das Leistungsmodul so kompakt aufgebaut sein, wobei die Leistungsbauteile jeweils mit derselben Wärmesenke, insbesondere des Kühlkörpers, wärmeleitfähig verbunden sind.

In einer bevorzugten Ausführungsform sind die Leistungsbauteile jeweils an einen Fluidkanal wärmeleitfähig angekoppelt, wobei die Fluidkanäle - insbesondere innerhalb der Wärmesenke, bevorzugt eines durch die Wärmesenke gebildeten einen Hohlraum umschließenden Gehäuses - miteinander fluidgängig verbunden sind. Vorteilhaft kann der Kühlkörper so platzsparend und aufwandsgünstig bereitgestellt werden, und einen großen elektrischen Isolationswiderstand zwischen den spannungsführenden Teilen bereitstellen.

In einer bevorzugten Ausführungsform weist ein Teil des Kühlkörpers einen Einlass für das Fluid auf, und der weitere Teil des Kühlkörpers einen Auslass für das Fluid auf. Die Fluidkanäle sind jeweils mittels eines Durchlasses in dem Isolator - insbesondere innerhalb des Kühlkörpers - miteinander verbunden, insbesondere fluidgängig verbunden. Vorteilhaft kann so die einzige elektrische Verbindung zwischen den Teilen des Kühlkörpers über ein insbesondere elektrisch leitfähiges Fluid, beispielsweise Kühlwasser, gebildet sein. Die übrigen Teile, insbesondere der Teil und der weitere Teil des Kühlkörpers, sind mittels des elektrischen Isolators voneinander elektrisch isoliert.

In einer bevorzugten Ausführungsform weist der Durchlass eine Durchlassöffnung auf, deren Querschnittsfläche quer zu einer Flussrichtung des Fluidstromes kleiner ausgebildet ist, als eine durch den Isolator getrennte Kontaktfläche der Teile. Vorteilhaft kann der elektrische Isolationswiderstand so auf eine kleine Durchlassöffnung begrenzt sein, welche das Fluid, insbesondere Kühlwasser, führt.

In einer bevorzugten Ausführungsform ist der Isolator durch ein Isolierelement gebildet. Weiter bevorzugt an das elektrische Isolierelement wenigstens ein oder nur ein den Durchbruch umschließender Zapfen angeformt, welcher sich in ein Teil der Wärmesenke, insbesondere Maschinengehäuse einer elektrischen Maschine oder Kühlkörper eines Inverters, hineinerstreckt. Vorteilhaft kann so der in dem Durchbruch durch das elektrische Isolierelement isolierte Fluidkanalabschnitt gegenüber dem einen Teil elektrisch isoliert sein. Weiter bevorzugt weist das Isolierelement zwei an das elektrische Isolierelement angeformte Zapfen auf, welche sich jeweils in ein Teil der Wärmesenke, insbesondere den Kühlkörper des Inverters beziehungsweise das Maschinengehäuse hineinerstrecken. Vorteilhaft kann so der in dem Durchbruch gebildete Fluidkanalabschnitt gegenüber dem weiteren Teil elektrisch isoliert sein.

Vorteilhaft kann das Isolierelement so im Bereich des Durchbruchs eine im Vergleich zu einer Dickenerstreckung des Isolierelements verlängerte Isolationsstrecke bereitstellen, durch welche die Teile der Wärmesenke voneinander elektrisch isoliert sind.

Bevorzugt ist der Durchbruch zylinderförmig gebildet. Der Zapfen ist in dieser Ausführungsform hohlzylinderförmig gebildet. Der Durchbruch kann in einer anderen Ausführungsform einen vieleckigen Querschnitt aufweisen. Vorteilhaft kann der Zapfen an den Isolator, insbesondere das Isolierelement angeformt sein.

In einer bevorzugten Ausführungsform ist der Isolator durch eine Kunststoffschicht gebildet. In einer bevorzugten Ausführungsform ist der Isolator ein insbesondere temperaturbeständiger Thermoplast. Vorteilhaft kann der Isolator so an die Kontaktflächen der Teile anschmiegend angepasst sein.

Die Kunststoffschicht ist beispielsweise eine Polyethylenschicht, Polypropylenschicht, PEEK-Schicht (PEEK = Poly-Ether-Ether-Keton, PES-Schicht PES = Poly-Ether-Sulfon), oder PPS-Schicht (PPS = Poly-PhenylenSulfid), oder Polyimidschicht. Vorteilhaft kann der Isolator so aufwandsgünstig als Festkörper bereitgestellt sein.

Der Isolator ist in einer anderen Ausführungsform durch ein Silikongummi gebildet. Vorteilhaft kann der Isolator so neben einer Isolationsfunktion auch eine Abdichtfunktion des Durchlasses aufweisen. Der Isolator ist in diesem Ausführungsbeispiel den Durchlass umgebend angeordnet und ausgebildet.

In einer bevorzugten Ausführungsform ist das Fluid polar ausgebildet. Das Fluid ist bevorzugt ein wasserhaltiges Fluid. Vorteilhaft kann des Fluild so aufwandsgünstig bereitgestellt sein und eine gute Wärmekapazität aufweisen. Das Fluid weist bevorzugt Wasser und ein Glykol, insbesondere Diethylenglykol, auf. Vorteilhaft kann das Fluid so frostgeschützt sein.

Das Fluid ist in einer anderen Ausführungsform elektrisch isolierend ausgebildet. Das Fluid ist in dieser Ausführungsform beispielsweise durch ein Öl oder einen Ester, insbesondere Pentaerithritester gebildet. Vorteilhaft kann so auch im Bereich des Durchbruchs kein Strom zwischen den Teilen der Wärmesenke, insbesondere Gehäuseteilen des Kühlkörpers fließen.

Bevorzugt weist das Leistungsmodul einen Leitwertsensor oder Widerstandssensor auf, welcher ausgebildet ist, einen durch das Fluid gebildeten elektrischen Leitwert beziehungsweise elektrischen Übergangswiderstand zwischen den Teilen zu erfassen. Vorteilhaft kann so ein Leckstrom, welcher durch das Fluid von dem Teil des Kühlkörpers zu dem weiteren Teil des Kühlkörpers fließt, erfasst werden.

Bevorzugt ist der Widerstandssensor ausgebildet, ein den elektrischen Widerstand zwischen den Teilen repräsentierendes Ausgangssignal zu erzeugen. Bevorzugt kann in Abhängigkeit des Ausgangssignals - beispielsweise von einer Steuereinheit der elektrischen Maschine, ein Fehlersignal erzeugt werden. Die Steuereinheit kann das Fehlersignal beispielsweise auf einem Datenbus bereitstellen.

Die Erfindung betrifft auch ein Elektrofahrzeug oder Hybridfahrzeug mit einem Leistungsmodul der vorbeschriebenen Art. Das Fahrzeug weist eine elektrische Maschine zum Antrieb des Fahrzeugs und einen Inverter auf. Bei dem Fahrzeug ist ein Teil des Kühlkörpers mit dem Inverter elektrisch verbunden, und der weitere Teil mit der elektrischen Maschine elektrisch verbunden.

Das Leistungsbauteil ist bevorzugt durch den Inverter gebildet, und das weitere Leistungsbauteil ist bevorzugt durch die elektrische Maschine gebildet. Vorteilhaft kann so sowohl der Inverter, als auch die elektrische Maschine durch denselben Kühlkörper gekühlt werden.

In einer bevorzugten Ausführungsform ist der Teil der Wärmesenke mit einem Massepotential des Inverters verbunden, und der weitere Teil der Wärmesenke mit dem Massepotential der elektrischen Maschine verbunden. Vorteilhaft kann so das Massepotential des Inverters von dem Massepotential der elektrischen Maschine mittels der Isolationsschicht und des so ausgebildeten Leistungsmoduls - bis auf einen Übergangswiderstand, der durch das Kühlwasser gebildet ist - voneinander elektrisch isoliert sein.

Die Erfindung wird nun im Folgenden anhand von Figuren und weiteren Ausführungsbeispielen beschrieben. Weitere vorteilhafte Ausführungsvarianten ergeben sich aus einer Kombination der in den Figuren und abhängigen Ansprüchen beschriebenen Merkmale.

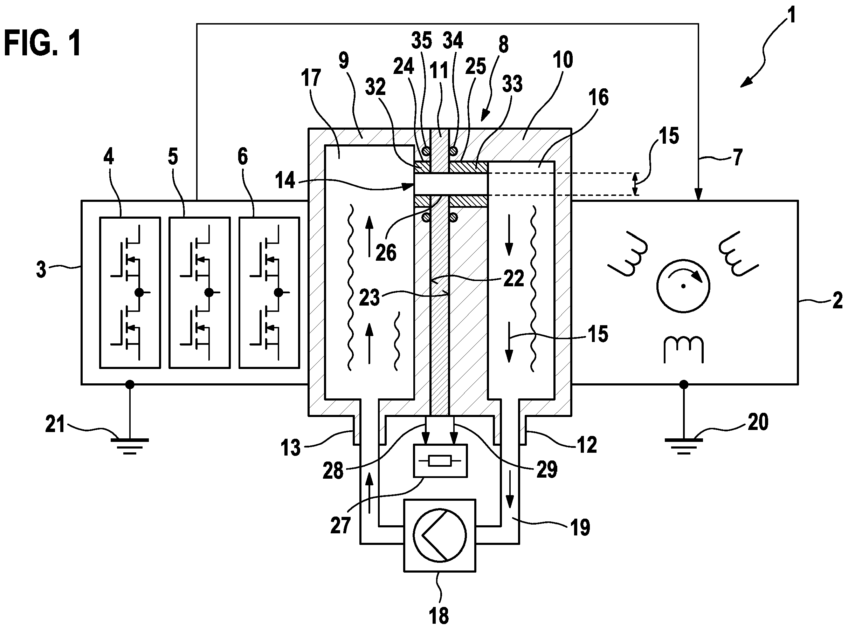

Figur 1 zeigt ein Ausführungsbeispiel durch ein Antriebsmodul, umfassend eine elektrische Maschine und einen Inverter zu Bestromen der Maschine, wobei ein Maschinengehäuse und der Inverter jeweils durch ein Fluid kühlbar an eine Wärmesenke gekoppelt sind.

Figur 1 zeigt - schematisch - ein Ausführungsbeispiel durch ein Antriebsmodul 1 in einer Schnittdarstellung. Das Antriebsmodul 1 weist eine elektrische Maschine 2 auf, und einen Inverter 3. Der Inverter 3 ist ausgebildet, die elektrische Maschine 2 - insbesondere zum Erzeugen eines magnetischen Drehfeldes - zu bestromen. Der Inverter 3 umfasst in diesem Ausführungsbeispiel drei Halbleiterschalter-Halbbrücken 4, 5 und 6, welche jeweils zum Erzeugen eines pulsmodulierten Stromes zum Betreiben der Maschine 2 ausgebildet sind. Die Halbleiterschalter-Halbbrücken 4, 5 und 6 sind jeweils zum Erzeugen von Verlustwärme ausgebildet.

Das Antriebsmodul 1 umfasst auch eine Wärmesenke 8, welche in diesem Ausführungsbeispiel als zum Fluidführen ausgebildeter Kühlkörper ausgebildet ist. Die Wärmesenke 8 ist mit dem Inverter 3, insbesondere den Halbleiterschalter-Halbbrücken 4, 5 und 6, wärmeleitfähig verbunden und ist ausgebildet, von dem Inverter 3 erzeugte Verlustwärme aufzunehmen. Die Wärmesenke 8 ist auch mit der elektrischen Maschine 2 wärmeleitfähig verbunden und ausgebildet, von der elektrischen Maschine 2 Verlustwärme aufzunehmen.

Die Wärmesenke 8 umfasst in diesem Ausführungsbeispiel zwei Teile, welche gemeinsam zu einer einteiligen Wärmesenke 8 zusammengefügt sind, nämlich einen Teil 9, welcher mit dem Inverter 3 wärmeleitfähig und elektrisch leitfähig verbunden ist, und einen weiteren Teil 10, welcher mit der elektrischen Maschine 2 wärmeleitfähig und elektrisch leitfähig verbunden ist. Die Teile 9 und 10 sind in diesem Ausführungsbeispiel jeweils aus Aluminium oder Kupfer gebildet und so jeweils elektrisch leitfähig ausgebildet, so dass der Teil 9 der Wärmesenke ein Massepotential 21 des Inverters führen kann und der weitere Teil 10 ein Massepotential 20 der elektrischen Maschine führen kann.

Der Teil 9 und der weitere Teil 10 umschließen jeweils einen Hohlraum, welcher zum Fluidführen eines Fluidstroms 15 ausgebildet ist. Die Hohlräume 16 und 17 bilden jeweils einen Fluidkanal, in dem der Fluidstrom 15 fließen kann, und Verlustwärme von den Leistungsbauteilen 2 und 3 aufnehmen kann.

Der Teil 9 umschließt dazu einen Hohlraum 17. Die Teile 9 und 10 sind in diesem Ausführungsbeispiel jeweils durch ein den Hohlraum 17 bzw. 16 umschließendes Aluminiumgehäuse gebildet. Der weitere Teil 10 kann ein Teil eines Gehäuses der elektrischen Maschine 2 sein. Die Hohlräume 16 und 17 bilden jeweils einen Fluidkanal, in dem der Fluidstrom 15 fließen kann, und Verlustwärme von den Leistungsbauteilen 2 und 3 aufnehmen kann.

Der weitere Teil 10 weist eine Koppelfläche 23 zum mechanischen und wärmeleitfähigen Ankoppeln an den Teil 9 auf. Der Teil 9 weist eine Koppelfläche 22 zum mechanischen und wärmeleitfähigen Ankoppeln an den weiteren Teil 10 auf. Die Wärmekontaktflächen 22 und 23 sind jeweils durch einen elektrischen Isolator, in diesem Ausführungsbeispiel eines elektrisches Isolierelement 11 voneinander elektrisch isoliert, und wärmeleitfähig verbunden. Daselektrische Isolierelement 11 ist in diesem Ausführungsbeispiel wärmeleitfähig ausgebildet. Das elektrische Isolierelement 11 ist beispielsweise durch eine Kunststoffschicht, insbesondere Thermoplastschicht, oder eine Kunststoffplatte gebildet.

Die von den Teilen der Wärmesenke, insbesondere dem Teil 9 und dem weiteren Teil 10 umschlossenen Hohlräume 17 bzw. 16, sind mittels eines einen Durchlass bildenden Durchbruchs 14 miteinander fluidgängig verbunden. Dazu weist der Teil 9 eine Durchbruchöffnung 24 auf, welche zu einer Durchbruchöffnung 25 des weiteren Teils 10 gegenüberliegt.

Das elektrische Isolierelement 11 weist einen Durchbruch 26 auf, welcher zwischen den Durchbruchöffnungen 24 und 25 eingeschlossen ist. Auf diese Weise ist ein durchgehender Durchbruch 14 gebildet, welcher in diesem Ausführungsbeispiel eine Durchbruchfläche 15 aufweist.

Ein Durchbruchvolumen des Durchbruchs 14 kann auf diese Weise eine Kühlwassermenge führen, welche einen elektrischen Isolationswiderstand zwischen dem Teil 9 und dem weiteren Teil 10 der Wärmesenke 8 verringern kann. Vorteilhaft ist der Durchbruch 14, insbesondere eine Durchbruchfläche 15 des Durchbruchs 14, hinreichend klein ausgebildet, sodass ein elektrischer Übergangswiderstand zwischen den Teilen 9 und 10 einen dort fließenden Leckstrom auf weniger als 200 Milliampere begrenzen kann.

Figur 1 zeigt auch eine Variante zu dem Antriebsmodul, bei dem an das elektrische Isolierelement 11 ein den Durchbruch 14 umschließender Zapfen 33 angeformt ist, welcher sich in das Teil 10, insbesondere Maschinengehäuse, hineinerstreckt, so dass der in dem Durchbruch durch das elektrische Isolierelement isolierte Fluidkanalabschnitt gegenüber dem Teil 10 elektrisch isoliert ist. Das Isolierelement weist in der Variante auch ein an das elektrische Isolierelement 11 angeformten Zapfen 32 auf, welcher sich in das Teil 9, insbesondere den Kühlkörper des Inverters 3, hineinerstreckt, so dass der in dem Durchbruch 14 gebildete Fluidkanalabschnitt gegenüber dem Teil 9 elektrisch isoliert ist.

Vorteilhaft kann können die Teile 9 und 10 der Wärmesenke 8 so einen großen elektrischen Isolationswiderstand gegeneinander aufweisen.

Der Teil 10 ist in diesem Ausführungsbeispiel mittels einer Dichtung 34, insbesondere O-Ring, gegen das Isolierelement 11 abgedichtet. Der Teil 9 ist in diesem Ausführungsbeispiel mittels einer Dichtung 35, insbesondere O-Ring, gegen das Isolierelement 11 abgedichtet. Die Dichtungen 34 und 35 können in einer anderen Ausführungsform an das Isolierelement 11 angespritzt sein.

Der Teil 9 weist einen Anschluss 13, insbesondere Anschlussstutzen auf, welcher an den Hohlraum 17 fluidgängig ankoppelt und ausgebildet ist, ein in dem Hohlraum 17 fließendes Fluid aus der Wärmesenke 8 herauszuführen, und einer Fluidpumpe 18 zuzuführen. Der weitere Teil 10 weist in diesem Ausführungsbeispiel einen Fluidanschluss 12, insbesondere Anschlussstutzen auf, welcher mittels einer Fluidleitung 19 mit der Fluidpumpe 18 verbunden ist, und in diesem Ausführungsbeispiel als Einlass der Wärmesenke 8 ausgebildet ist. Ein Fluidstrom 15 kann, angetrieben durch die Fluidpumpe 18, durch den Hohlraum 17, und weiter durch den Durchbruch 14 bis in den Hohlraum 16 erzeugt werden, und so Verlustwärme sowohl von dem Inverter 2 als auch der elektrischen Maschine 2 aufnehmen.

Der Fluidstrom kann - anders als in Figur 1 dargestellt - auch von der Fluidpumpe von der Maschine 2 zum Inverter 3 geführt werden. In diesem Ausführungsbeispiel wird der elektrische Übergangswiderstand zwischen dem Teil 9 und dem weiteren Teil 10 der Wärmesenke durch das in dem Durchbruch 14 gehaltene Fluidvolumen, insbesondere Kühlwasservolumen, gebildet. Das Kühlwasser ist in diesem Ausführungsbeispiel ein mineralarmes Kühlwasser, beispielsweise destilliertes Wasser, oder ein Wasser-Glykol-Gemisch.

Die elektrische Maschine 2, insbesondere ein Gehäuse der elektrischen Maschine 2, ist in diesem Ausführungsbeispiel mit einer Motormasse 20 elektrisch verbunden. Der Inverter 3, insbesondere ein Gehäuse des Inverters 3, ist mit einer Invertermasse 21 verbunden. Die Massepotentiale der Massen 20 und 21 sind in diesem Ausführungsbeispiel mittels der elektrisch isoliert ausgebildeten Wärmesenke 8, insbesondere der wärmeleitfähig miteinander verbundenen, und elektrisch voneinander isolierten Teile 9 und 10 voneinander isoliert. Auf diese Weise sind die Massepotentiale 21 und 20 der Leistungsbauteile, insbesondere des Inverters 3 beziehungsweise der elektrischen Maschine 2, innerhalb der Wärmesenke voneinander getrennt.

Das Leistungsmodul 1 weist in diesem Ausführungsbeispiel auch einen Leitwertsensor 27 auf, welcher eingangsseitig mittels einer Verbindungsleitung 28 mit dem Teil 9 und mittels einer Verbindungsleitung 29 mit dem Teil 10 verbunden ist. Der Leitwertsensor ist ausgebildet, einen zwischen den Teilen 9 und 10 der Wärmesenke 8 gebildeten elektrischen Übergangsleitwert zu erfassen und ein den Leitwert repräsentierendes Ausgangssignal zu erzeugen.

Das Fluid ist beispielsweise ein Wasser-Glykolgemisch nach einer Spezifikation SAE J1034, ASTM D 4985, beispielsweise Glysantin^{®} G40^{®} oder G48^{®}. Das Fluid weist neben Ethlenglykol bevorzugt einen Korrosionsinhibitior, insbesondere ein Silikat, weiter bevorzugt ein Salz einer organischen Säure auf.

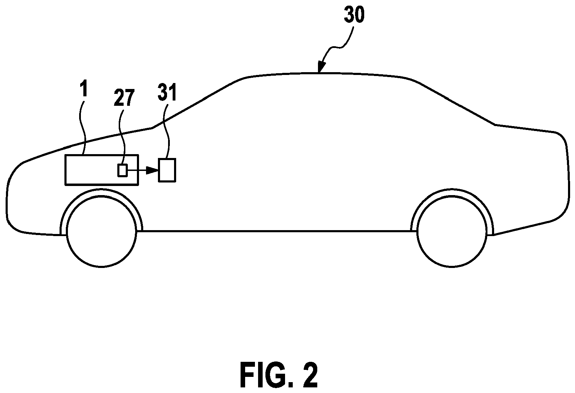

Figur 2 zeigt ein Fahrzeug, insbesondere Elektrofahrzeug mit einem Leistungsmodul, insbesondere dem in Figur 1 dargestellten Leistungsmodul 1. Das Elektrofahrzeug 30 weist ein Steuergerät 31 auf, welches ausgebildet ist, in Abhängigkeit des Ausgangssignals des Leitwertsensors 27 bei Überschreiten eines vorbestimmten Leitwerts ein Fehlersignal erzeugen. Bei einer Wartung des Fahrzeugs kann in Abhängigkeit des Fehlersignals der Leitwert des Fluids 15 überprüft werden und das Fluid 15 getauscht werden.

## Patentansprüche

1. Leistungsmodul (1), insbesondere Antriebsmodul, mit einer zum Fluidführen (15) ausgebildeten Wärmesenke (8, 9, 10) und wenigstens zwei zueinander verschiedenen mit der Wärmesenke (8, 9, 10) wärmeleitfähig und elektrisch leitfähig verbundenen Leistungsbauteilen (2, 3),
**dadurch gekennzeichnet, dass**
die Leistungsbauteile (2, 3) jeweils ausgebildet sind, zueinander verschiedene elektrische Potentiale (20, 21), insbesondere Massepotentiale (20, 21) zu führen und die Wärmesenke (8) wenigstens oder nur zwei Teile (9, 10) umfasst, welche jeweils einen durch einen Hohlraum gebildeten Fluidkanal (16, 17) zum Führen eines Fluidstromes (15) aufweisen und mittels eines elektrischen Isolators (11) derart miteinander verbunden sind, dass die Teile (9, 10) jeweils von einem beide Teile (9, 10) kühlenden Fluidstrom (15) durchflossen werden können und derart elektrisch voneinander isoliert sind, dass die elektrischen Potentiale (20, 21) der Leistungsbauteile (2, 3) innerhalb der Wärmesenke (8, 9, 10) voneinander getrennt sind.

2. Leistungsmodul (1) nach Anspruch 1,
**dadurch gekennzeichnet, dass**
der Isolator (11) durch ein elektrisch isolierendes insbesondere flaches Isolierelement gebildet ist, welche durch die Teile (9, 10) kontaktiert ist und zwischen den Teilen (9, 10) eingeschlossen ist.

3. Leistungsmodul (1) nach einem der vorhergehenden Ansprüche 1 oder 2,
**dadurch gekennzeichnet, dass**
die Teile (9, 10) der Wärmesenke (8) jeweils durch ein Gehäuseteil gebildet sind, wobei die Gehäuseteile insbesondere trennbar miteinander verbunden sind und den Isolator (11), insbesondere Isolierschicht, zwischeneinander einschließen.

4. Leistungsmodul (1) nach einem der vorhergehenden Ansprüche,
**dadurch gekennzeichnet, dass**
die Leistungsbauteile (2, 3) jeweils an einen Fluidkanal (16, 17) wärmeleitfähig angekoppelt sind, wobei die Fluidkanäle miteinander fluidgängig innerhalb der Wärmesenke verbunden sind.

5. Leistungsmodul (1) nach Anspruch 4,
**dadurch gekennzeichnet, dass**
ein Teil (9) einen Einlass (13) für das Fluid (15) aufweist und das weitere Teil einen Auslass für das Fluid (15) aufweist, und die Fluidkanäle (16, 17) mittels eines Durchlasses (14, 26) in dem Isolator (11) miteinander verbunden sind.

6. Leistungsmodul (1) nach Anspruch 5,
**dadurch gekennzeichnet, dass**
der Durchlass (14, 24, 25, 26) eine Durchlassöffnung aufweist, deren Querschnittsfläche (15) quer zu einer Flussrichtung des Fluidstromes (15) kleiner ausgebildet ist als eine durch den Isolator (11) getrennte Kontaktfläche (22, 23) der Teile (9, 10).

7. Leistungsmodul (1) nach einem der vorhergehenden Ansprüche,
**dadurch gekennzeichnet, dass**
der Isolator (11) durch eine Kunststoffschicht gebildet ist.

8. Leistungsmodul (1) nach einem der vorhergehenden Ansprüche,
**dadurch gekennzeichnet, dass**
der Isolator (11)durch ein Isolierelement gebildet, an das wenigstens ein den Durchbruch (14) umschließender Zapfen (33, 34) angeformt ist, welcher sich in ein Teil (9, 10) der Wärmesenke (8) hineinerstreckt oder zwei Zapfen auf, welche sich jeweils in eines der beide Teile (9, 10) der Wärmesenke (8) hineinerstrecken..

9. Leistungsmodul (1) nach einem der vorhergehenden Ansprüche,
**dadurch gekennzeichnet, dass**
das Fluid (15) polar ausgebildet ist und das Leistungsmodul (1) einen Leitwertsensor (27) aufweist, welcher ausgebildet ist, einen durch das Fluid (15) gebildeten elektrischen Leitwert zwischen den Teilen (9, 10) zu erfassen.

10. Elektrofahrzeug oder Hybridfahrzeug mit einem Leistungsmodul (1) nach einem der vorhergehenden Ansprüche,
**dadurch gekennzeichnet, dass**
das Fahrzeug eine elektrische Maschine (2) zum Antrieb des Fahrzeugs und einen Inverter (3) aufweist, wobei ein Teil (9) der Wärmesenke (8) mit dem Inverter (3) elektrisch verbunden ist und der weitere Teil (10) mit der elektrischen Maschine (2) elektrisch verbunden ist.

11. Elektrofahrzeug nach Anspruch 9,
**dadurch gekennzeichnet, dass**
der Teil (9) der Wärmesenke (8) mit einem Massepotential (21) des Inverters (3) verbunden ist und der andere Teil (10) der Wärmesenke (8) mit dem Massepotential (20) der elektrischen Maschine (2) verbunden ist.

## Claims

1. Power module (1), in particular drive module, having a heat sink (8, 9, 10), which is designed for conducting fluid (15), and at least two power components (2, 3), which are different from one another and are thermally conductively and electrical conductively connected to the heat sink (8, 9, 10),
**characterized in that**
the power components (2, 3) are each designed to carry electric potentials (20, 21), in particular earth potentials (20, 21), which are different from one another, and the heat sink (8) comprises at least or only two parts (9, 10) which each have a fluid channel (16, 17), which is formed by a cavity, for conducting a fluid flow (15) and are connected to one another by means of an electrical insulator (11) in such a way that a fluid flow (15) that cools both parts (9, 10) can flow through each of the parts (9, 10) and the parts are electrically insulated from one another in such a way that the electric potentials (20, 21) of the power components (2, 3) are separated from one another within the heat sink (8, 9, 10).

2. Power module (1) according to Claim 1,
**characterized in that**
the insulator (11) is formed by an electrically insulating, in particular flat, insulating element which is contacted by the parts (9, 10) and is enclosed between the parts (9, 10).

3. Power module (1) according to either of the preceding Claims 1 and 2,
**characterized in that**
the parts (9, 10) of the heat sink (8) are each formed by a housing part, wherein the housing parts are, in particular separably, connected to one another and enclose the insulator (11), in particular insulating layer, between one another.

4. Power module (1) according to any of the preceding claims,
**characterized in that**
the power components (2, 3) are each thermally conductively coupled to a fluid channel (16, 17), wherein the fluid channels are connected to one another within the heat sink such that fluid can pass.

5. Power module (1) according to Claim 4,
**characterized in that**
a part (9) has an inlet (13) for the fluid (15) and the further part has an outlet for the fluid (15), and the fluid channels (16, 17) are connected to one another by means of a passage (14, 26) in the insulator (11).

6. Power module (1) according to Claim 5,
**characterized in that**
the passage (14, 24, 25, 26) has a passage opening, the cross-sectional area (15) of the passage opening being smaller transversely to a flow direction of the fluid flow (15) than a contact area (22, 23) of the parts (9, 10) which is separated by the insulator (11).

7. Power module (1) according to any of the preceding claims,
**characterized in that**
the insulator (11) is formed by a plastics layer.

8. Power module (1) according to any of the preceding claims,
**characterized in that**
the insulator (11) formed by an insulating element on which at least one pin (33, 34) surrounding the aperture (14) is integrally formed, the pin extending into a part (9, 10) of the heat sink (8) or two pins on, which respectively extend into one of the two parts (9, 10) of the heat sink (8).

9. Power module (1) according to any of the preceding claims,
**characterized in that**
the fluid (15) is polar and the power module (1) has a conductance sensor (27) which is designed to detect an electrical conductance, which is formed by the fluid (15), between the parts (9, 10).

10. Electric vehicle or hybrid vehicle having a power module (1) according to any of the preceding claims,
**characterized in that**
the vehicle has an electric machine (2) for driving the vehicle and has an inverter (3), wherein a part (9) of the heat sink (8) is electrically connected to the inverter (3) and the further part (10) is electrically connected to the electric machine (2).

11. Electric vehicle according to Claim 9,
**characterized in that**
the part (9) of the heat sink (8) is connected to an earth potential (21) of the inverter (3) and the other part (10) of the heat sink (8) is connected to the earth potential (20) of the electric machine (2).

## Revendications

1. Module de puissance (1), en particulier module d'entraînement, comprenant un dissipateur thermique (8, 9, 10) réalisé pour conduire (15) un fluide, et au moins deux composants de puissance (2, 3) différents l'un de l'autre et reliés de manière thermiquement et électriquement conductrice au dissipateur thermique (8, 9, 10),
**caractérisé en ce que**
les composants de puissance (2, 3) sont respectivement réalisés pour conduire des potentiels électriques (20, 21) différents les uns des autres, en particulier des potentiels de masse (20, 21), et le dissipateur thermique (8) comprend au moins ou seulement deux parties (9, 10) qui présentent respectivement une conduite de fluide (16, 17) formée par une cavité et destinée à conduire un courant de fluide (15), et qui sont reliées l'une à l'autre au moyen d'un isolateur électrique (11) de telle sorte que les parties (9, 10) peuvent être traversées respectivement par un courant de fluide (15) refroidissant les deux parties (9, 10) et sont isolées électriquement l'une par rapport à l'autre de telle sorte que les potentiels électriques (20, 21) des composants de puissance (2, 3) sont séparés l'un de l'autre à l'intérieur du dissipateur thermique (8, 9, 10).

2. Module de puissance (1) selon la revendication 1,
**caractérisé en ce que**
l'isolateur (11) est formé par un élément isolant, en particulier plat, électriquement isolant avec lequel les parties (9, 10) entrent en contact et qui est enfermé entre les parties (9, 10).

3. Module de puissance (1) selon l'une quelconque des revendications précédentes 1 ou 2,
**caractérisé en ce que**
les parties (9, 10) du dissipateur thermique (8) sont formées respectivement par une partie de boîtier, dans lequel les parties de boîtier sont reliées ensemble, en particulier de manière séparable, et enferment entre elles l'isolateur (11), en particulier la couche isolante.

4. Module de puissance (1) selon l'une quelconque des revendications précédentes,
**caractérisé en ce que**
les composants de puissance (2, 3) sont couplés respectivement à une conduite de fluide (16, 17) de manière thermiquement conductrice, les conduites de fluide étant reliées ensemble de manière fluidique à l'intérieur du dissipateur thermique.

5. Module de puissance (1) selon la revendication 4,
**caractérisé en ce que**
qu'une partie (9) présente une entrée (13) pour le fluide (15) et l'autre partie présente une sortie pour le fluide (15), et les conduites de fluide (16, 17) sont reliées ensemble au moyen d'un passage (14, 26) dans l'isolateur (11).

6. Module de puissance (1) selon la revendication 5,
**caractérisé en ce que**
le passage (14, 24, 25, 26) présente une ouverture de passage dont la superficie de la section (15) transversalement à un sens d'écoulement du courant de fluide (15) est plus petite qu'une surface de contact (22, 23) des parties (9, 10), séparée par l'isolateur (11).

7. Module de puissance (1) selon l'une quelconque des revendications précédentes,
**caractérisé en ce que**
l'isolateur (11) est formé par une couche de matière plastique.

8. Module de puissance (1) selon l'une quelconque des revendications précédentes,
**caractérisé en ce que**
l'isolateur (11) formé par un élément isolant auquel est rapporté au moins un tenon (33, 34) entourant le passage (14) et qui s'étend dans une partie (9, 10) du dissipateur thermique (8), ou bien deux tenons sur, qui s'étendent respectivement dans l'une des deux parties (9, 10) du dissipateur thermique (8).

9. Module de puissance (1) selon l'une quelconque des revendications précédentes,
**caractérisé en ce que**
le fluide (15) est réalisé de manière polaire et le module de puissance (1) présente un capteur de conductance (27) qui est réalisé pour détecter une conductance électrique formée par le fluide (15) entre les deux parties (9, 10).

10. Véhicule électrique ou véhicule hybride, comprenant un module de puissance (1) selon l'une quelconque des revendications précédentes,
**caractérisé en ce que**
le véhicule présente une machine électrique (2) pour entraîner le véhicule et un onduleur (3), dans lequel une partie (9) du dissipateur thermique (8) est reliée électriquement à l'onduleur (3), et la partie (10) supplémentaire est reliée électriquement à la machine électrique (2).

11. Véhicule électrique selon la revendication 9,
**caractérisé en ce que**
la partie (9) du dissipateur thermique (8) est reliée à un potentiel de masse (21) de l'onduleur (3), et l'autre partie (10) du dissipateur thermique (8) est reliée au potentiel de masse (20) de la machine électrique (2).
